(19) **Europäisches Patentamt**
**European Patent Office**
**Office européen des brevets**

(11) **EP 3 984 073 B1**

(12) **FASCICULE DE BREVET EUROPÉEN**

(45) Date de publication et mention
de la délivrance du brevet:
**30.08.2023 Bulletin 2023/35**

(21) Numéro de dépôt: **20731867.6**

(22) Date de dépôt: **11.06.2020**

(51) Classification Internationale des Brevets (IPC):
***H10N 70/00*** *(2023.01)*

(52) Classification Coopérative des Brevets (CPC):
**H10N 70/883; H10N 70/026; H10N 70/20; H10N 70/826**

(86) Numéro de dépôt international:
**PCT/EP2020/066242**

(87) Numéro de publication internationale:
**WO 2020/249699 (17.12.2020 Gazette 2020/51)**

(54) **PROCÉDÉ DE FABRICATION D'UNE CELLULE MÉMOIRE RÉSISTIVE DE TYPE OXRAM**

VERFAHREN ZUR HERSTELLUNG EINER RESISTIVEN OXRAM-SPEICHERZELLE

METHOD FOR MANUFACTURING AN OXRAM RESISTIVE MEMORY CELL

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **12.06.2019 FR 1906261**

(43) Date de publication de la demande:
**20.04.2022 Bulletin 2022/16**

(73) Titulaires:
 • **Commissariat à l'Energie Atomique et aux Energies Alternatives**
 **75015 Paris (FR)**
 • **Weebit Nano Ltd**
 **4527713 Hod-HaSharon (IL)**

(72) Inventeurs:
 • **MOLAS, Gabriel**
 **38054 Grenoble cedex 09 (FR)**
 • **PICCOLBONI, Guiseppe**
 **37124 Verona (IT)**
 • **REGEV, Amir**
 **Modiin (IL)**
 • **CASTELLANI, Gaël**
 **38054 Grenoble cedex 09 (FR)**
 • **NODIN, Jean-François**
 **38054 Grenoble cedex 09 (FR)**

(74) Mandataire: **Cabinet Camus Lebkiri**
 **25 rue de Maubeuge**
 **75009 Paris (FR)**

(56) Documents cités:
 WO-A1-2015/179593 JP-A- 2016 076 655
 US-A1- 2011 095 255 US-A1- 2013 264 536
 US-A1- 2016 020 388 US-A1- 2016 351 256

 • Ambrosi Elia ET AL: "Impact of oxide and electrode materials on the switching characteristics of oxide ReRAM devices", FARADAY DISCUSSIONS, vol. 213, 1 January 2019 (2019-01-01), pages 87-98, XP093022201, GB ISSN: 1359-6640, DOI: 10.1039/C8FD00106E

**Description**

**DOMAINE TECHNIQUE**

La présente invention est relative au domaine des mémoires résistives à accès aléatoire RRAM (pour « Résistive Random Access Memories » en anglais). L'invention concerne un procédé pour déterminer une valeur d'un ou plusieurs paramètres de fabrication d'une cellule mémoire résistive, dans le but d'améliorer la fenêtre de programmation de la cellule mémoire résistive. L'invention concerne également un procédé de fabrication d'une cellule mémoire résistive ayant une fenêtre de programmation élevée.

**ÉTAT DE LA TECHNIQUE**

Les mémoires résistives, en particulier les mémoires résistives à base d'oxyde (OxRAM, pour « Oxyde-based Random Access Memories »), sont des mémoires non-volatiles ayant pour but de remplacer les mémoires de type Flash. En plus d'une forte densité d'intégration, elles présentent une vitesse de fonctionnement élevée, une grande endurance et une bonne compatibilité avec les procédés de fabrication utilisés actuellement dans l'industrie microélectrique, en particulier avec le procédé de fin de ligne (BEOL, pour « Back-End Of Line » en anglais) de la technologie CMOS.

Les mémoires résistives OxRAM comprennent une multitude de cellules mémoire, appelées également points mémoire. Chaque cellule mémoire OxRAM est constituée d'une capacité M-I-M (Métal-Isolant-Métal) comprenant un matériau actif de résistance électrique variable, en général un oxyde de métal de transition (ex. $HfO_2$, $Ta_2O_5$, $TiO_2$...), disposé entre deux électrodes métalliques. La cellule mémoire commute de manière réversible entre deux états de résistance, qui correspondent à des valeurs logiques « 0 » et « 1 » utilisées pour coder un bit d'information. Dans certains cas, plus de deux états de résistance peuvent être générés, ce qui permet de stocker plusieurs bits d'information dans une même cellule mémoire.

L'information est écrite dans la cellule mémoire en la basculant d'un état fortement résistif (ou « HRS », pour « High Résistance State » en anglais), appelé également état « OFF », à un état faiblement résistif (« LRS », pour « Low Résistance State »), ou état « ON ». À l'inverse, pour effacer l'information de la cellule mémoire, celle-ci est basculée de l'état faiblement résistif (« OFF ») vers l'état fortement résistif (« ON »).

Le changement de résistance de la cellule mémoire est gouverné par la formation et la rupture d'un filament conducteur de section nanométrique entre les deux électrodes.

Immédiatement après sa fabrication, la cellule mémoire résistive est dans un état vierge caractérisé par une résistance (dite initiale) très élevée, bien supérieure à la résistance de la cellule lorsqu'elle est dans l'état fortement résistif. La couche d'oxyde est en effet isolante dans son état initial. Pour que la cellule mémoire puisse être utilisée, il est nécessaire d'accomplir une étape dite de « forming ». Cette étape consiste en un claquage partiellement réversible de l'oxyde afin de générer pour la première fois le filament conducteur (et donc placer la cellule mémoire dans l'état faiblement résistif). Après ce claquage, la couche d'oxyde initialement isolante devient active et la cellule peut commuter entre l'état faiblement résistif et l'état fortement résistif par des opérations d'effacement et d'écriture.

L'étape de forming est accomplie en appliquant entre les deux électrodes de la cellule mémoire une tension (dite de « forming ») de valeur bien supérieure à la tension nominale de fonctionnement de la cellule mémoire (utilisée lors des cycles d'écriture-effacement suivants), par exemple une tension de l'ordre de 2,5 V pour une tension nominale de l'ordre de 1,5 V. Pour obtenir une tension de forming compatible avec la tension d'alimentation du circuit auquel appartient la cellule mémoire, une solution consiste à ajuster certains paramètres de fabrication de la cellule mémoire. Par exemple, la tension de forming peut être augmentée en augmentant l'épaisseur de la couche d'oxyde ou en diminuant l'épaisseur des électrodes.

Un inconvénient des mémoires résistives OxRAM est la grande variabilité de la résistance électrique d'une cellule mémoire à l'état fortement résistif. Cette variabilité s'observe non seulement au fur et à mesure des cycles d'écriture-effacement sur une même cellule, mais également de cellule à cellule.

Ce problème de variabilité de la résistance électrique est un réel frein à l'industrialisation, car il induit une diminution de la fenêtre de programmation, définie comme le rapport entre la résistance dans l'état fortement résistif et la résistance dans l'état faiblement résistif. Il existe par conséquent un risque de perdre l'information stockée dans la cellule mémoire. Ce souci demeure malgré de nombreux efforts réalisés dans les domaines de la programmation des mémoires résistives OxRAM. En effet, la forme, la durée et l'amplitude maximale des impulsions de programmation peuvent être choisies dans le but de maximiser la fenêtre de programmation sur un nombre de cycles d'écriture-effacement le plus élevé possible.

Par ailleurs, des études ont été menées récemment afin de remplacer les oxydes de métal de transition par des matériaux moins coûteux et plus facilement industrialisables : les oxydes de silicium. Le document US2016/276411 décrit une matrice de cellules mémoire comprenant chacune une couche de matériau résistif à base d'oxyde de silicium sous-stoechiométrique ($SiO_x$, avec x compris entre 1 et 2) disposée entre deux électrodes, par exemple en titane. Le document JP2016 076655, décrit une cellule mémoire résistive de type OxRAM comprenant une couche en oxyde de silicium.

## RÉSUMÉ DE L'INVENTION

L'invention a pour but de fournir un moyen supplémentaire d'optimiser la fenêtre de programmation d'une cellule mémoire résistive, par exemple d'une cellule à base d'oxyde de silicium.

Selon un premier aspect de l'invention, on tend vers cet objectif en prévoyant un procédé pour déterminer au moins une valeur d'au moins un paramètre de fabrication d'une cellule mémoire résistive, la cellule mémoire résistive comprenant un empilement de couches minces, ledit procédé comprenant les étapes suivantes :

- fournir plusieurs cellules mémoire de référence correspondant à plusieurs variantes technologiques de l'empilement de couches minces ;
- mesurer pour chaque cellule mémoire de référence une valeur de résistance initiale ;
- déterminer pour chaque cellule mémoire de référence une valeur d'un paramètre de programmation choisi parmi la résistance dans un état fortement résistif et la fenêtre de programmation ;
- établir une relation entre le paramètre de programmation et la résistance initiale à partir des valeurs de résistance initiale et des valeurs du paramètre de programmation ;
- déterminer ladite au moins une valeur dudit au moins un paramètre de fabrication pour laquelle le paramètre de programmation est supérieur ou égal à une valeur cible, à partir de ladite relation entre le paramètre de programmation et la résistance initiale et d'au moins une relation de dépendance entre la résistance initiale et ledit au moins un paramètre de fabrication.

Le procédé de détermination selon le premier aspect de l'invention permet de mettre en évidence la relation qui existe entre la résistance initiale de la cellule mémoire et la résistance de la cellule mémoire dans l'état fortement résistif ou la fenêtre de programmation. Connaissant cette relation et la dépendance entre résistance initiale et paramètre(s) de fabrication, il est possible de déterminer au moins une valeur optimale d'un ou plusieurs paramètres de fabrication de la cellule mémoire.

La fenêtre de programmation d'une cellule mémoire résistive peut donc dorénavant être optimisée en ajustant un ou plusieurs paramètres de fabrication de la cellule mémoire, en plus des conditions de programmation ou du choix des matériaux.

Les paramètres de fabrication ne sont donc plus ajustés en fonction d'une valeur cible de la tension de forming, mais en fonction d'une valeur cible de la résistance dans l'état fortement résistif ou (directement) une valeur cible de la fenêtre de programmation.

De préférence, le procédé de détermination comprend les étapes suivantes :

- déterminer, à partir de ladite relation entre le paramètre de programmation et la résistance initiale, au moins une valeur de la résistance initiale pour laquelle le paramètre de programmation est supérieur ou égal à la valeur cible ; et
- déterminer ladite au moins une valeur dudit au moins un paramètre de fabrication à partir de ladite au moins une valeur de la résistance initiale.

Dans un premier mode de mise en oeuvre du procédé de détermination, le paramètre de programmation est la résistance dans l'état fortement résistif et l'étape de détermination des valeurs du paramètre de programmation comporte les opérations suivantes :

- programmer les cellules mémoire de référence dans l'état fortement résistif ;
- mesurer pour chaque cellule mémoire de référence une valeur de résistance dans l'état fortement résistif.

La résistance dans l'état fortement résistif est de préférence une fonction polynomiale du second degré du logarithme de la résistance initiale.

Dans un deuxième mode de mise en oeuvre du procédé de détermination, le paramètre de programmation est la fenêtre de programmation et l'étape de détermination des valeurs du paramètre de programmation comporte les opérations suivantes :

- programmer les cellules mémoire de référence dans un état faiblement résistif ;
- mesurer pour chaque cellule mémoire de référence une valeur de résistance dans l'état faiblement résistif ;
- programmer les cellules mémoire de référence dans l'état fortement résistif ;
- mesurer pour chaque cellule mémoire de référence une valeur de résistance dans l'état fortement résistif ; et

- calculer pour chaque cellule mémoire de référence une valeur de la fenêtre de programmation à partir des valeurs mesurées de résistance dans l'état faiblement résistif et de résistance dans l'état fortement résistif.

De préférence, l'empilement de couches minces comporte une première électrode disposée sur un substrat, une couche d'oxyde disposée sur la première électrode et une deuxième électrode disposée sur la couche d'oxyde.

Dans un mode de mise en oeuvre préférentiel du procédé de détermination, ledit au moins un paramètre de fabrication est choisi parmi l'épaisseur de la deuxième électrode, l'épaisseur de la couche d'oxyde et la proportion en oxygène dans la couche d'oxyde.

Un deuxième aspect de l'invention concerne un procédé de fabrication d'une cellule mémoire résistive. Ce procédé de fabrication comprend les étapes suivantes :

- déterminer une valeur d'au moins un paramètre de fabrication, en suivant un procédé de détermination selon le premier aspect de l'invention ;
- former sur un substrat un empilement comprenant successivement une première électrode, une couche d'oxyde et une deuxième électrode, en appliquant la valeur dudit au moins un paramètre de fabrication.

La couche d'oxyde est de préférence formée d'un oxyde de silicium sous-stœchiométrique ($SiO_x$) ou d'un oxyde de silicium poreux. Dans un oxyde de silicium sous-stœchiométrique, le coefficient stœchiométrique ($x$) de l'oxygène (i.e. la proportion en oxygène) est strictement inférieur à 2.

La première électrode est par exemple en nitrure de titane et la deuxième électrode est par exemple en titane.

L'invention a également pour but de fabriquer une cellule mémoire résistive de type OxRAM ayant une fenêtre de programmation élevée, la cellule mémoire comprenant une couche en oxyde de silicium.

Selon un troisième aspect de l'invention, on tend vers cet objectif en prévoyant un procédé de fabrication comprenant les étapes suivantes :

- déterminer des valeurs de paramètres de fabrication permettant à la cellule mémoire résistive d'avoir une résistance initiale comprise entre $10^7 \ \Omega$ et $3.10^9 \ \Omega$, de préférence entre $3.10^7 \ \Omega$ et $10^9 \ \Omega$ ;
- former sur un substrat un empilement comprenant successivement une première électrode, la couche en oxyde de silicium et une deuxième électrode, en appliquant lesdites valeurs de paramètres de fabrication.

Le procédé de fabrication selon le troisième aspect de l'invention peut également présenter une ou plusieurs des caractéristiques ci-dessous, considérées individuellement ou selon toutes les combinaisons techniquement possibles :

- les paramètres de fabrication sont l'épaisseur de la deuxième électrode, l'épaisseur de la couche d'oxyde et la proportion en oxygène dans la couche d'oxyde ;
- l'oxyde de silicium est poreux et la proportion en oxygène dans la couche en oxyde de silicium est comprise entre 1,6 et 2, de préférence entre 1,8 et 1,9 ;
- l'oxyde de silicium est poreux et l'épaisseur de la couche en oxyde de silicium est comprise entre 4 nm et 7 nm ;
- l'oxyde de silicium est poreux et l'épaisseur de la deuxième électrode est comprise entre 3 nm et 7 nm ;
- l'oxyde de silicium est non-poreux et la proportion en oxygène dans la couche en oxyde de silicium est comprise entre 1 et 1,6, de préférence entre 1,2 et 1,4 ;
- l'oxyde de silicium est non-poreux et l'épaisseur de la couche en oxyde de silicium est comprise entre 3 nm et 4 nm ;
- l'oxyde de silicium est non-poreux et l'épaisseur de la deuxième électrode est comprise entre 4 nm et 6 nm ;
- la couche en oxyde de silicium est formée par pulvérisation cathodique ;
- les première et deuxième électrodes sont formées par pulvérisation cathodique; et
- la première électrode est en nitrure de titane et la deuxième électrode est en titane.

## BRÈVE DESCRIPTION DES FIGURES

D'autres caractéristiques et avantages de l'invention ressortiront clairement de la description qui en est donnée ci-dessous, à titre indicatif et nullement limitatif, en référence aux figures annexées, parmi lesquelles :

- la figure 1 représente schématiquement un premier mode de mise en oeuvre d'un procédé pour déterminer une valeur de paramètre de fabrication d'une cellule mémoire résistive ;
- la figure 2 illustre différents régimes de dépôt lors de la pulvérisation d'une source de silicium en présence d'oxygène ;
- la figure 3 représente, pour une pluralité de cellules mémoire de référence $TiN/SiO_x/Ti$, la résistance dans l'état fortement résistif en fonction de la résistance initiale ;

- la figure 4 représente, pour les mêmes cellules mémoire de référence, la résistance dans l'état fortement résistif en fonction de la tension de forming.

Pour plus de clarté, les éléments identiques ou similaires sont repérés par des signes de référence identiques sur l'ensemble des figures.

## DESCRIPTION DÉTAILLÉE

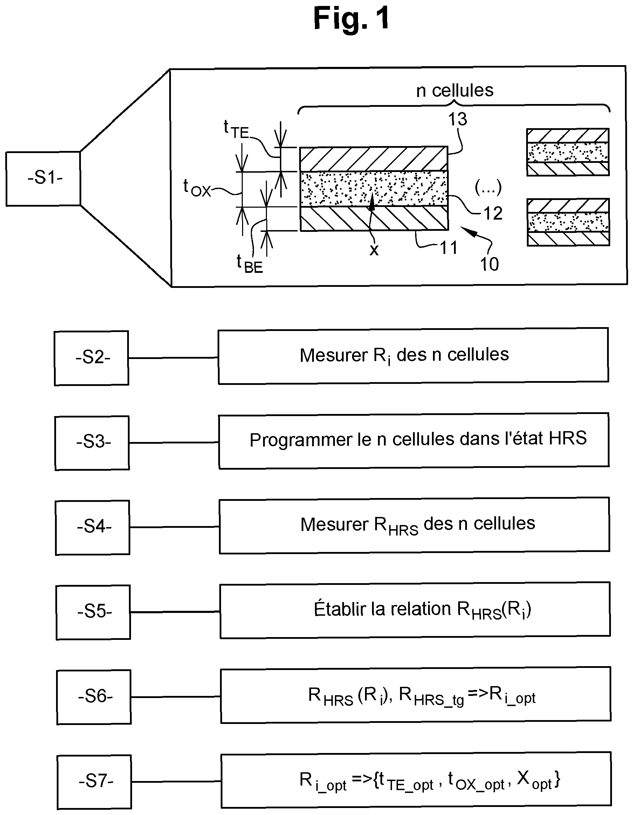

[Fig 1] : La figure 1 représente des étapes S1 à S7 d'un procédé pour déterminer une valeur d'au moins un paramètre de fabrication d'une cellule mémoire résistive, selon un premier mode de mise en oeuvre de l'invention. Lorsque la cellule mémoire résistive est fabriquée en suivant cette valeur de paramètre, la fenêtre de programmation de la cellule mémoire atteint une valeur maximale ou une valeur proche de la valeur maximale. La fenêtre de programmation PW (aussi appelée « fenêtre mémoire ») d'une cellule mémoire résistive est égale à la résistance de la cellule dans l'état fortement résistif (ou « HRS », pour « High Resistance State » en anglais), notée ci-après $R_{HRS}$, divisée par la résistance de la même cellule dans l'état faiblement résistif (ou « LRS », pour « Low Resistance State » en anglais), notée ci-après $R_{LRS}$ (PW = $R_{HRS}/R_{LRS}$).

La cellule mémoire résistive dont on cherche à améliorer la fenêtre de programmation comprend un empilement de couches minces (< 100 nm d'épaisseur chacune). De façon classique, cet empilement est formé sur un substrat, par exemple en silicium, et comporte :

- une première électrode 11 disposée sur le substrat et appelée ci-après « électrode inférieure » ;
- une couche de matériau à résistance électrique variable 12, aussi appelé « matériau résistif », disposée sur la première électrode 11; et
- une deuxième électrode 13 disposée sur la couche de matériau résistif et appelée ci-après « électrode supérieure ».

La cellule mémoire résistive est de préférence une cellule de mémoire vive à base d'oxyde, communément appelée « OxRAM » (pour « Oxyde-based Random Access Memory » en anglais). Le matériau résistif est alors un oxyde, par exemple un oxyde de métal de transition (ex. $HfO_2$, $Ta_2O_5$, $TiO_2$...) ou un oxyde de silicium. Les électrodes peuvent être formées de silicium dopé, d'un siliciure, d'un métal (ex. titane, tantale, tungstène...) ou d'un matériau à caractère métallique, tel que le nitrure de titane (TiN) ou le nitrure de tantale (TaN).

La première étape S1 du procédé consiste à fournir un nombre n de cellules mémoire de référence 10, où n est en entier naturel supérieur ou égal à 2, de préférence supérieur ou égale à 20. Plus le nombre n de cellule mémoire de référence 10 est important, plus le procédé de détermination sera précis. Pour ne pas alourdir inutilement la figure 1, seules trois cellules mémoire de référence 10 ont été représentées. Les cellules mémoire de référence 10 et la cellule mémoire résistive à fabriquer comprennent un même type d'empilement de couches minces. Les empilements sont dits de même type lorsque le nombre de couches actives est identique et les matériaux utilisés sont de même nature. Par exemple, l'empilement des cellules mémoire de référence 10 (et de la cellule mémoire résistive à fabriquer) comporte une électrode inférieure 11 en nitrure de titane, une couche de matériau résistif 12 en oxyde de silicium ($SiO_x$) et une électrode supérieure 13 en titane (empilement de type $TiN/SiO_x/Ti$).

Les cellules mémoire de référence 10 diffèrent dans les valeurs de leurs paramètres de fabrication. Parmi ces paramètres de fabrication, on peut citer à titre d'exemple l'épaisseur $t_{OX}$ de la couche d'oxyde 12, l'épaisseur $t_{TE}$ de l'électrode supérieure 13 et le coefficient stoechiométrique x de la couche d'oxyde 12 (correspondant à une proportion en oxygène par rapport aux autres éléments formant le matériau résistif). Les cellules mémoire de référence 10 peuvent présenter différentes valeurs d'un même paramètre de fabrication (par exemple l'épaisseur $t_{TE}$ de l'électrode supérieure) ou différentes valeurs de plusieurs paramètres de fabrication. Chaque cellule mémoire de référence 10 est fabriquée suivant un ensemble de paramètres de fabrication et au moins un paramètre de fabrication de chaque ensemble diffère des autres ensembles de paramètres. En ce sens, les cellules mémoire de référence 10 représentent des variantes technologiques d'un même empilement de couches minces.

Dans le cas d'un empilement de type $TiN/SiO_x/Ti$, les paramètres de fabrication qui varient entre les n cellules mémoire de référence 10 sont de préférence l'épaisseur $t_{OX}$ de la couche de $SiO_x$ 12, l'épaisseur $t_{TE}$ de l'électrode supérieure 13 en titane et la proportion en oxygène x du $SiO_x$ (l'épaisseur de l'électrode inférieure n'a pas d'influence sur la résistance initiale, son épaisseur est par exemple de l'ordre de 40 nm). Par exemple, l'épaisseur $t_{OX}$ de la couche de $SiO_x$ 12 varie entre 1 nm et 20 nm, l'épaisseur $t_{TE}$ de l'électrode supérieure 13 en titane varie entre 1 nm et 20 nm et la proportion en oxygène x du $SiO_x$ varie entre 1 et 2. L'oxyde de silicium peut donc être sous-stoechiométrique (x<2) ou être du dioxyde de silicium (x = 2). Le dioxyde de silicium est de préférence poreux, tandis que l'oxyde de silicium sous-stoechiométrique peut être poreux ou non-poreux (i.e. dépourvu de pores).

Dans le cas d'un empilement métal/matériau diélectrique « high-k »/métal, où le métal de l'électrode supérieure (ex. Hf, Ti, Ta...) joue le rôle du guetteur d'oxygène pour le matériau diélectrique « high-k » (i.e. de haute permittivité

diélectrique, ex. HfO$_2$, TiO$_2$, Ta$_2$O$_5$...), l'épaisseur de la couche de matériau diélectrique « high-k » peut varier entre 1 nm et 20 nm et l'épaisseur de l'électrode supérieure (couche de guetteur de l'oxygène) peut varier entre 1 nm et 20 nm. Dans le cas d'un matériau diélectrique « high-k » de type oxyde métallique « MO$_x$ », où M est un métal de transition (ex. Hf, Ti, Ta...), la proportion en oxygène x peut en outre varier entre 1 et une valeur correspondant à l'oxyde stœchiométrique (x = 2 pour le HfO$_2$ ou le TiO$_2$, x = 2,5 pour le Ta$_2$O$_5$...).

La résistance initiale R$_i$ de chaque cellule mémoire de référence 10 est ensuite mesurée lors d'une étape S2. La résistance initiale est la résistance électrique obtenue à l'issue de la fabrication de la cellule mémoire, avant que ne soit formé pour la première fois le filament conducteur (autrement dit, avant l'étape de « forming »). La résistance initiale R$_i$ peut être mesurée en appliquant une tension de mesure U$_1$ (par exemple 100 mV) entre les électrodes 11 et 13 de la cellule mémoire 10, en mesurant le courant I$_1$ de la cellule (à travers la couche d'oxyde 12) soumise à cette tension U$_1$ puis en calculant le rapport de la tension de mesure U$_1$ sur le courant I$_1$ mesuré (R$_i$ = U$_1$/I$_1$).

Les cellules mémoire de référence 10 sont ensuite programmées dans l'état fortement résistif (« HRS ») lors d'une étape S3. Une première tension dite de « forming » (par exemple de l'ordre de 3 V) est appliquée entre les électrodes des cellules mémoire 10 pour activer le matériau résistif et placer les cellules mémoire 10 dans l'état faiblement résistif (« LRS »), puis une deuxième tension dite d'effacement, de valeur absolue plus faible que la première tension est appliquée pour basculer les cellules mémoire de référence 10 de l'état faiblement résistif à l'état fortement résistif (la tension d'effacement est généralement négative, par exemple comprise entre -1 V et -2 V).

Puis, la résistance dans l'état fortement résistif R$_{HRS}$ est mesurée pour chaque cellule mémoire de référence 10 lors d'une étape S4. De façon analogue à la résistance initiale R$_i$, la résistance R$_{HRS}$ peut être mesurée en appliquant une tension de mesure U$_2$ (par exemple 100 mV) entre les électrodes de la cellule mémoire 10 (à l'état fortement résistif), en mesurant le courant I$_2$ de la cellule soumise à cette tension U$_2$ puis en calculant le rapport de la tension de mesure U$_2$ sur le courant I$_2$ mesuré (R$_{HRS}$ = U$_2$/I$_2$).

À l'étape S5, une relation R$_{HRS}$(R$_i$) entre la résistance dans l'état fortement résistif R$_{HRS}$ et la résistance initiale R$_i$ est établie à partir des valeurs de résistance R$_i$ et des valeurs de résistance R$_{HRS}$ mesurées respectivement lors des étapes S2 et S4. Par exemple, les valeurs de résistances R$_{HRS}$ et R$_i$ des cellules mémoire de référence 10 peuvent être reportées sur un graphique. Chaque point du graphique correspond à une cellule mémoire de référence 10 et donc à une variante technologique de l'empilement (i.e. une combinaison de paramètres technologiques). Les points du graphique sont ensuite décrits, lors d'une opération dite d'ajustement (« fit » en anglais), par une courbe ou une équation du type R$_{HRS}$ = f(R$_i$). La relation R$_{HRS}$(R$_i$) peut donc prendre la forme d'une courbe ou d'une équation. La relation entre la résistance dans l'état fortement résistif R$_{HRS}$ et la résistance initiale R$_i$ s'écrit de préférence sous la forme d'un polynôme du second degré, avec comme variable le logarithme de la résistance initiale R$_i$.

L'étape S6 consiste à déterminer, à l'aide de la relation R$_{HRS}$(R$_i$), au moins une valeur R$_{i\_opt}$ de la résistance initiale R$_i$ pour laquelle la résistance dans l'état fortement résistif R$_{HRS}$ est supérieure ou égale à une valeur cible R$_{HRS\_tg}$ prédéterminée. Cette valeur cible R$_{HRS\_tg}$ peut être définie en fonction d'une valeur cible de la fenêtre de programmation (de préférence le maximum) ou peut être égale à un pourcentage du maximum de la résistance dans l'état fortement résistif R$_{HRS}$ (par exemple 90% du maximum de la résistance R$_{HRS}$). Le maximum de la résistance R$_{HRS}$ peut être déduit de la relation R$_{HRS}$(R$_i$) établie à l'étape S5.

Dans ce premier mode de mise en oeuvre du procédé, la résistance dans l'état faiblement résistif R$_{LRS}$ des cellules mémoire de référence 10 est supposée constante (et donc indépendante des paramètres technologiques). En effet, la résistance R$_{LRS}$ des cellules OXRAM programmées dans l'état faiblement résistif est contrôlée par le courant de programmation dans l'état faiblement résistif. Par exemple, pour un empilement de type TiN/SiO$_x$/Ti, la résistance R$_{LRS}$ vaut environ 10$^4$ Ω lorsque le courant de programmation est environ égal à 100 μA. Un maximum de la résistance dans l'état fortement résistif R$_{HRS}$ correspond alors à un maximum de la fenêtre de programmation.

Une valeur, plusieurs valeurs distinctes ou une plage (continue) de valeurs de la résistance initiale R$_i$ peuvent être ainsi obtenues à l'issue de l'étape S6, suivant la valeur cible choisie ou les valeurs de résistance R$_{HRS}$ prises en considération (supérieures à la valeur cible R$_{HRS\_tg}$ et/ou égales à la valeur cible R$_{HRS\_tg}$). Toutes ces valeurs peuvent être qualifiées de « optimales » ou « optimisées » dans la mesure où elles permettent d'approcher voire d'atteindre un maximum de la fenêtre de programmation.

Enfin, à l'étape S7, au moins une valeur optimale t$_{TE\_opt}$/t$_{OX\_opt}$/x$_{opt}$ d'un ou plusieurs paramètres de fabrication est déterminée à partir de la valeur optimale R$_{i\_opt}$ (ou des valeurs optimales) de résistance initiale. Ces paramètres de fabrication ne sont pas nécessairement les mêmes que ceux qui différencient les cellules mémoire de référence 10. Ils sont de préférence choisis parmi l'épaisseur t$_{OX}$ de la couche d'oxyde 12, l'épaisseur t$_{TE}$ de l'électrode supérieure 13 et la proportion en oxygène x dans la couche d'oxyde 12.

Dans un mode de mise en oeuvre préférentiel de l'étape S7, des valeurs de tous les paramètres de fabrication ayant une influence sur la résistance initiale R$_i$ sont déterminées à partir de la valeur optimale R$_{i\_opt}$ de résistance initiale. Dans une variante de mise en oeuvre, des valeurs d'une partie seulement de ces paramètres de fabrication sont déterminées à partir de la valeur optimale R$_{i\_opt}$ de résistance initiale. Les valeurs des autres paramètres de fabrication (y compris ceux n'ayant pas d'influence sur la résistance initiale, par exemple l'épaisseur t$_{BE}$ de l'électrode inférieure 11 dont le rôle est d'assurer un bon contact électrique) peuvent être déterminées d'une autre façon. Elles peuvent notamment être imposées par des contraintes d'intégration.

La valeur optimale d'un paramètre de fabrication peut être déterminée à partir d'une valeur optimale $R_{i\_opt}$ de résistance initiale connaissant la dépendance de ce paramètre sur la résistance initiale $R_i$. Par exemple, la résistance initiale $R_i$ d'une cellule mémoire résistive augmente avec l'épaisseur $t_{OX}$ de la couche d'oxyde 12 et avec la proportion en oxygène x. Par contre, elle diminue lorsque l'épaisseur $t_{TE}$ de l'électrode supérieure 13 augmente (jusqu'à un certain seuil).

Un plan d'expérience peut être mis en oeuvre afin d'établir des relations de dépendance entre la résistance initiale $R_i$ et les différents paramètres de fabrication. Ce plan d'expérience peut notamment consister à faire varier les trois paramètres de fabrication susmentionnés (épaisseur $t_{OX}$ de la couche d'oxyde 12, épaisseur $t_{TE}$ de l'électrode supérieure 13 et proportion en oxygène x dans la couche d'oxyde 12), de préférence en croisant toutes les valeurs de paramètres, et à mesurer la résistance initiale correspondant à chaque ensemble de valeurs.

Dans le cas de l'empilement TiN/SiOx/Ti, les relations suivantes ont été obtenues en fixant deux paramètres puis en faisant varier le dernier paramètre (avec $R_i$ en $\Omega$, x sans unité, $t_{OX}$ et $t_{TE}$ en nm) :

[Math 1]

$$log(R_i) = 12,6.x - 16.6$$

avec $t_{OX} = t_{TE} =$ 5 nm.

Ainsi, l'équation Math 1 ci-dessus exprime la variation de la résistance initiale $R_i$ en fonction du coefficient stoechiométrique x de l'oxygène et où les épaisseurs $t_{ox}$ de la couche d'oxyde 12 et $t_{TE}$ de l'électrode supérieure 13 ont été fixées à 5 nm.

[Math 2]

$$R_i = 4.10^{-6} \times exp(5,4099.t_{OX})$$

avec $t_{TE} =$ 5 nm et x = 1,8.

Ainsi, l'équation Math 2 ci-dessus exprime la variation de la résistance initiale $R_i$ en fonction de l'épaisseur $t_{ox}$ de la couche d'oxyde 12 et où le coefficient stoechiométrique x de l'oxygène a été fixé à 1,8 et l'épaisseur $t_{TE}$ de l'électrode supérieure 13 a été fixée à 5 nm.

[Math 3]

$$R_i = 9.10^9 \times exp(-0,97.t_{TE})$$

avec $t_{OX} =$ 5 nm et x = 1,9.

Ainsi, l'équation Math 3 ci-dessus exprime la variation de la résistance initiale Ri en fonction de l'épaisseur $t_{TE}$ de l'électrode supérieure 13 et où l'épaisseur $t_{ox}$ de la couche d'oxyde 12 a été fixée à 5 nm et où le coefficient stoechiométrique x de l'oxygène a été fixé à 1,9.

Les équations ci-dessus ont été obtenues à partir de valeurs expérimentales et sont dépendantes de l'équipement de dépôt utilisé.

Lorsqu'on dispose de plusieurs valeurs optimales $R_{i\_opt}$ de la résistance initiale, plusieurs valeurs optimales du ou des paramètres de fabrication peuvent être obtenues.

Dans un deuxième mode de mise en oeuvre du procédé, non représenté par les figures, on suppose que la résistance dans l'état faiblement résistif $R_{LRS}$ des cellules mémoire de référence 10 varie. Le procédé comprend alors, en plus des étapes S1-S4 décrites précédemment, une étape de programmation des cellules mémoire de référence 10 dans l'état faiblement résistif, une étape de mesure de la résistance $R_{LRS}$ des cellules mémoire de référence 10 dans l'état faiblement résistif et une étape de calcul des fenêtres de programmation des cellules mémoire de référence 10 à partir des valeurs mesurées des résistances $R_{LRS}$ et $R_{HRS}$. La résistance $R_{LRS}$ des cellules mémoire de référence 10 à l'état faiblement résistif est avantageusement mesurée avant l'étape S3 de programmation des cellules mémoire de référence 10 dans l'état fortement résistif, après l'étape de forming (qui constitue donc l'étape de programmation des cellules mémoire de référence 10 dans l'état faiblement résistif).

Au lieu de déterminer une relation $R_{HRS}(R_i)$ entre la résistance dans l'état fortement résistif $R_{HRS}$ et la résistance initiale $R_i$, on détermine à l'étape S5 une relation entre la fenêtre de programmation et la résistance initiale. Une valeur cible de la fenêtre de programmation est alors considérée lors de l'étape S6 (au lieu d'une valeur cible de la résistance dans l'état fortement résistif $R_{HRS}$).

Un exemple de mise en oeuvre du procédé de détermination selon l'invention va maintenant être décrit.

La cellule mémoire résistive dont on cherche à optimiser la fenêtre de programmation ainsi que les cellules mémoire de référence 10 prévues à cet effet comprennent l'empilement de couches minces $TiN/SiO_x/Ti$ décrit précédemment.

L'oxyde de silicium est dans cet exemple poreux et a été obtenu par pulvérisation cathodique réactive dans une chambre de dépôt sous vide. La chambre de dépôt est équipée d'une cible de silicium et comprend deux entrées de gaz, l'une pour l'oxygène ($O_2$), l'autre pour un gaz neutre tel que l'argon. Le réacteur de pulvérisation comprend un générateur de tension continue (DC) et un magnétron. La polarisation de la source fournie par le générateur DC est avantageusement pulsée. Les paramètres ayant une influence sur la proportion en oxygène x du $SiO_x$ sont la puissance appliquée par le générateur DC, la pression de travail, les débits du gaz neutre et de l'oxygène, la fréquence, le rapport $T_{ON}/T_{REV}$ de la durée des phases de dépôt (état « ON » du générateur) sur la durée des phases de décharge électrostatique (état « OFF » du générateur) et le rapport cyclique des impulsions du générateur DC (égal à $T_{ON}/(T_{REV}+T_{ON})$).

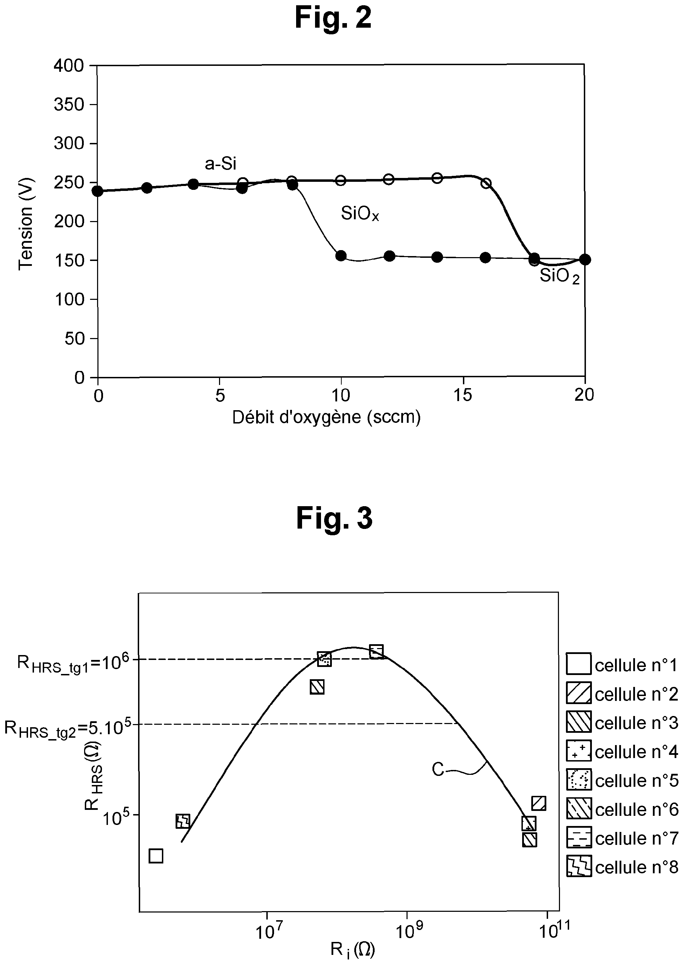

[Fig 2] : La figure 2 représente l'effet de la tension de polarisation appliquée à une cible de silicium (par le générateur DC) en fonction du débit d'oxygène entrant dans la chambre de dépôt (exprimé en sccm, l'abréviation de « Standard Cubic Centimeter per Minute » en anglais, soit le nombre de $cm^3$ de gaz s'écoulant par minute dans les conditions standard de pression et de température, i.e. à une température de 0 °C et une pression de 1013,25 hPa) sur l'état de la cible de silicium. La relation entre la tension de polarisation de la cible et le débit d'oxygène forme une hystérésis qui fixe l'état de la cible de silicium : silicium amorphe (a-Si) pour les faibles débits d'oxygène (< 7 sccm), oxyde de silicium sous-stoechiométrique ($SiO_x$, avec x compris entre 1 et 2 exclu) pour les débits d'oxygène intermédiaire (7-18 sccm) et dioxyde de silicium ($SiO_2$) pour les forts débits d'oxygène (> 18 sccm). La stoechiométrie de l'oxyde de silicium déposé peut ainsi être contrôlée grâce au débit d'oxygène entrant dans la chambre de dépôt.

Huit cellules mémoire de référence ont été fabriquées suivant différentes valeurs de paramètres de fabrication listées dans le tableau 1 ci-dessous. La stoechiométrie x du $SiO_x$ est contrôlée via le débit d'oxygène injecté dans la chambre. Les autres paramètres de dépôt sont identiques entre les 8 cellules mémoire de référence (température dans la chambre : 25 °C ; puissance du générateur DC : 1 kW, débit d'argon principal : 50 sccm ; débit d'argon en face arrière du substrat : 15 sccm ; pression dans la chambre : 1 à 3 mTorr (1 mTorr = 133.3 mPa) suivant le débit d'oxygène ; vanne de la pompe cryogénique en position intermédiaire).

[Tableau 1]

| cellule n° | $t_{OX}$ (nm) | Débit d'oxygène $D_{O2}$ (sccm) | Proportion en oxygène x | $t_{TE}$ (nm) | $R_i$ (Ω) | $R_{HRS}$ (Ω) |
|---|---|---|---|---|---|---|
| 1 | 5 | 6 | 1,9 | 5 | 5E6 | 5E4 |
| 2 | 7 | 6 | 1,9 | 5 | 4E10 | 1E5 |
| 3 | 5 | 6 | 1,9 | 7 | 9E7 | 8E5 |
| 4 | 7 | 6 | 1,9 | 7 | 3E10 | 9E4 |
| 5 | 5 | 7 | 2 | 7 | 2E8 | 1E6 |
| 6 | 7 | 5 | 1,8 | 5 | 4E10 | 7E4 |
| 7 | 5 | 7 | 2 | 5 | 1E9 | 1E6 |
| 8 | 5 | 5 | 1,8 | 5 | 3E6 | 1E5 |

Le tableau 1 donne également pour ces 8 cellules mémoire de référence les valeurs mesurées de la résistance initiale $R_i$ et de la résistance dans l'état fortement résistif $R_{HRS}$. La résistance dans l'état faiblement résistif $R_{LRS}$ est supposée constante et égale à $10^4$ Ω. La relation qui lie les valeurs de débit d'oxygène $D_{O2}$ (entre 4 sccm et 7 sccm) et les valeurs de la proportion en oxygène x est la suivante :

[Math 4]

$$D_{O2} = 10.x - 13$$

Pour un débit d'oxygène $D_{O2}$ supérieur ou égal à 7 sccm, la proportion en oxygène x est égale à 2.

[Fig 3] : La figure 3 est un graphe sur lequel ont été reportées les valeurs mesurées de résistance $R_i$ et $R_{HRS}$ des 8 cellules mémoire de référence. Ces points ont ensuite été extrapolés au moyen d'une courbe C. L'équation de la courbe C (obtenue expérimentalement) est la suivante :

[Math 5]

$$R_{HRS} = -2,2.10^5.\left(log(R_i)\right)^2 + 4.10^6.log(R_i) - 2.10^7$$

avec $R_i$ et $R_{HRS}$ en $\Omega$.

La courbe C, en forme de cloche ou parabole, montre qu'il existe un maximum de la résistance dans l'état fortement résistif $R_{HRS}$ - et donc un maximum de la fenêtre de programmation - pour une résistance initiale $R_i$ d'environ $10^8\,\Omega$. Une explication à cette dépendance en forme de cloche pourrait être la suivante : à faible résistance initiale $R_i$, il n'est pas possible d'atteindre une valeur de résistance $R_{HRS}$ élevée du fait d'une limitation intrinsèque de la résistance de la cellule mémoire. A forte résistance initiale $R_i$, une tension de forming élevée est nécessaire pour pouvoir utiliser la cellule mémoire et cette tension élevée génère une importante quantité de défauts dans la couche de $SiO_x$. Comme les défauts sont toujours présents lors de l'effacement de la cellule mémoire (retour à l'état fortement résistif causé par une dissolution du filament conducteur), la résistance de l'état fortement résistif est réduite.

D'après la courbe C de la figure 3, une résistance initiale $R_i$ comprise entre $3.10^7\,\Omega$ et $10^9\,\Omega$ correspond à une résistance dans l'état fortement résistif $R_{HRS}$ supérieure ou égale à $R_{HRS\_tg1} = 10^6\,\Omega$. Pour obtenir une fenêtre de programmation supérieure ou égale à 100, la cellule mémoire résistive ($TiN/SiO_x/Ti$) sera donc fabriquée de sorte que sa résistance initiale $R_i$ soit comprise entre $3.10^7\,\Omega$ et $10^9\,\Omega$.

Il existe de multiples combinaisons de valeurs de paramètre pour obtenir une résistance initiale $R_i$ comprise entre $3.10^7\,\Omega$ et $10^9\,\Omega$. Comme indiqué précédemment, l'une de ces combinaisons peut être obtenue en fixant un paramètre (pour des raisons d'intégration par exemple), puis en faisant varier les deux autres paramètres. Pour faciliter la recherche d'une résistance initiale $R_i$ comprise entre $3.10^7\,\Omega$ et $10^9\,\Omega$, et compte tenu de l'application visée, l'épaisseur $t_{OX\_opt}$ de la couche d'oxyde 12 peut être fixée à une valeur comprise entre 4 nm et 7 nm. De façon alternative ou additionnelle, l'épaisseur $t_{TE\_opt}$ de l'électrode supérieure 13 peut être fixée à une valeur comprise entre 3 nm et 7 nm. De façon alternative ou additionnelle, la concentration en oxygène $x_{opt}$ peut être fixée à une valeur comprise entre 1,6 et 2 (soit un débit d'oxygène compris entre 5 sccm et 8 sccm), de préférence entre 1,8 et 1,9.

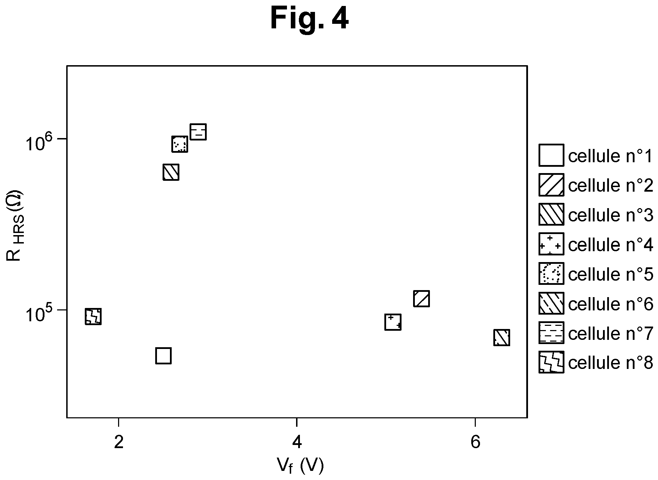

[Fig 4] : La figure 4 représente les valeurs de résistance dans l'état fortement résistif $R_{HRS}$ des 8 cellules mémoire de référence précédentes, associées aux valeurs de la tension de forming $V_f$ qui ont été appliquées à ces cellules. Cette figure montre à titre de comparaison que, lorsqu'on ajuste les paramètres de fabrication dans le but d'atteindre une tension de forming inférieure ou égale à 2 V (valeur typique pour être compatible avec le circuit d'alimentation de la mémoire), on obtient une fenêtre de programmation environ dix fois inférieure à la fenêtre de programmation maximale (atteinte pour une tension de forming 3 V environ). Le procédé de détermination selon l'invention permet donc une amélioration significative de la fenêtre de programmation des cellules mémoire résistive par rapport à la pratique courante.

Toujours d'après la courbe C de la figure 3, une résistance initiale $R_i$ comprise entre $10^7\,\Omega$ et $3.10^9\,\Omega$ correspond à une résistance dans l'état fortement résistif $R_{HRS}$ supérieure ou égale à $R_{HRS\_tg2} = 5.10^5\,\Omega$. Pour obtenir une fenêtre de programmation supérieure ou égale à 50, la cellule mémoire résistive ($TiN/SiO_x/Ti$) sera donc fabriquée de sorte que sa résistance initiale $R_i$ soit comprise entre $10^7\,\Omega$ et $3.10^9\,\Omega$.

L'oxyde de silicium $SiO_x$ peut être aussi non-poreux et sous-stœchiométrique (x<2). Pour faciliter la recherche d'une résistance initiale $R_i$ comprise entre $3.10^7\,\Omega$ et $10^9\,\Omega$, et compte tenu de l'application visée, l'épaisseur $t_{OX\_opt}$ de la couche d'oxyde 12 peut être fixée à une valeur comprise entre 3 nm et 4 nm. De façon alternative ou additionnelle, l'épaisseur $t_{TE\_opt}$ de l'électrode supérieure 13 peut être fixée à une valeur comprise entre 4 nm et 6 nm. De façon alternative ou additionnelle, la concentration en oxygène $x_{opt}$ peut être fixée à une valeur comprise entre 1 et 1,6, de préférence entre 1,2 et 1,4.

Plus généralement, une extrapolation de la courbe C permet de déterminer l'épaisseur de la couche d'oxyde $t_{ox}$ (non poreux) pour une valeur de $R_i$ souhaitée de la manière suivante : $log(Ri) = 1,1.t_{OX} + 0,7$ où l'épaisseur de l'électrode supérieure $t_{TE}$ a été fixée à 10 nm et où le coefficient stœchiométrique x a été fixé à 1,2.

De la même manière, une extrapolation de la courbe C permet de déterminer le coefficient stœchiométrique x pour une valeur de $R_i$ souhaitée de la manière suivante : $log(R_i) = 19.x + 16$ où l'épaisseur de la couche d'oxyde $t_{OX}$ (non poreux) a été fixée à 3 nm et où l'épaisseur de l'électrode supérieure $t_{TE}$ a été fixée à 5 nm.

Un autre aspect de l'invention concerne un procédé de fabrication d'une cellule mémoire résistive, et plus particulièrement d'une cellule mémoire OxRAM comprenant un empilement de type TiN/SiOx/Ti.

La fabrication de la cellule mémoire résistive comprend successivement une étape de dépôt de l'électrode inférieure 11 sur un substrat (par exemple en silicium), une étape de dépôt de la couche d'oxyde 12 sur l'électrode inférieure 11 et une étape de dépôt de l'électrode supérieure 13 sur la couche d'oxyde 12. En suivant à chaque étape la (ou les) valeur(s) de paramètre obtenue(s) grâce au procédé de détermination selon l'invention, la cellule mémoire résistive présentera une fenêtre de programmation élevée.

L'oxyde de silicium (qu'il soit poreux ou non-poreux) de l'empilement TiN/SiOx/Ti peut être obtenu par pulvérisation cathodique d'une source de silicium en présence d'oxygène. L'électrode inférieure en nitrure de titane et l'électrode supérieure en titane peuvent être formées par pulvérisation cathodique (réactive dans le cas du TiN).

On notera que l'invention n'est pas limitée aux modes de réalisation décrits en référence aux figures et des variantes pourraient être envisagées sans sortir du cadre de l'invention.

## Revendications

1. Procédé de fabrication d'une cellule mémoire résistive de type OxRAM comprenant une couche (12) en oxyde de silicium, ledit procédé comprenant les étapes suivantes :

    - déterminer des valeurs ($t_{TE\_opt}$, $t_{OX\_opt}$, $x_{opt}$) de paramètres de fabrication ($t_{TE}$, $t_{OX}$, x) permettant à la cellule mémoire résistive d'avoir une résistance initiale ($R_i$) avant que ne soit formé pour la première fois un filament conducteur comprise entre $10^7\ \Omega$ à $3.10^9\ \Omega$, de préférence entre $3.10^7\ \Omega$ et $10^9\ \Omega$ ;
    - former sur un substrat un empilement comprenant successivement une première électrode (11), la couche (12) en oxyde de silicium et une deuxième électrode (13), en appliquant lesdites valeurs de paramètres de fabrication.

2. Procédé selon la revendication 1, dans lequel les paramètres de fabrication sont l'épaisseur de la deuxième électrode ($t_{TE}$), l'épaisseur de la couche d'oxyde ($t_{OX}$) et la proportion en oxygène (x) dans la couche d'oxyde (12).

3. Procédé selon la revendication 2, dans lequel l'oxyde de silicium est poreux et dans lequel la proportion en oxygène (x) dans la couche (12) en oxyde de silicium est comprise entre 1,6 et 2, de préférence entre 1,8 et 1,9.

4. Procédé selon l'une des revendications 2 et 3, dans lequel l'oxyde de silicium est poreux et dans lequel l'épaisseur ($t_{OX}$) de la couche (12) en oxyde de silicium est comprise entre 4 nm et 7 nm.

5. Procédé selon l'une quelconque des revendications 2 à 4, dans lequel l'oxyde de silicium est poreux et dans lequel l'épaisseur ($t_{TE}$) de la deuxième électrode (13) est comprise entre 3 nm et 7 nm.

6. Procédé selon la revendication 2, dans lequel l'oxyde de silicium est non-poreux et dans lequel la proportion en oxygène (x) dans la couche (12) en oxyde de silicium est comprise entre 1 et 1,6, de préférence entre 1,2 et 1,4.

7. Procédé selon l'une des revendications 2 et 6, dans lequel l'oxyde de silicium est non-poreux et dans lequel l'épaisseur ($t_{OX}$) de la couche (12) en oxyde de silicium est comprise entre 3 nm et 4 nm.

8. Procédé selon l'une quelconque des revendications 2, 6 et 7, dans lequel l'oxyde de silicium est non-poreux et dans lequel l'épaisseur ($t_{TE}$) de la deuxième électrode (13) est comprise entre 4 nm et 6 nm.

9. Procédé selon l'une quelconque des revendications 1 à 8, dans lequel la couche (12) en oxyde de silicium est formée par pulvérisation cathodique.

10. Procédé selon l'une quelconque des revendications 1 à 9, dans lequel les première et deuxième électrodes (11, 13) sont formées par pulvérisation cathodique.

11. Procédé selon l'une quelconque des revendications 1 à 10, dans lequel la première électrode (11) est en nitrure de titane et la deuxième électrode (13) est en titane.

## Patentansprüche

1. Verfahren zur Herstellung einer resistiven Speicherzelle vom OxRAM-Typ, die eine Siliziumoxidschicht (12) umfasst, wobei das Verfahren folgende Schritte umfasst:

- Bestimmen der Werte ($t_{TE\_opt}$, $t_{OX\_opt}$, $x_{opt}$) von Herstellungsparametern ($t_{TE}$, $t_{OX}$, x), die es der resistiven Speicherzelle ermöglichen, einen Anfangswiderstand ($R_i$) zu haben, der zwischen $10^7$ $\Omega$ und $3.10^9$ $\Omega$, vorzugsweise zwischen $3.10^7$ $\Omega$ und $10^9$ $\Omega$ beträgt, bevor zum ersten Mal eine leitende Faser gebildet wird;
- Bilden auf einem Substrat einer Schichtung, die nacheinander eine erste Elektrode (11), die Siliziumoxidschicht (12) und eine zweite Elektrode (13) umfasst, wobei die Werte der Herstellungsparameter angewendet werden.

2. Verfahren nach Anspruch 1, bei dem die Herstellungsparameter die Dicke der zweiten Elektrode ($t_{TE}$), die Dicke der Oxidschicht ($t_{OX}$) und der Sauerstoffanteil (x) in der Oxidschicht (12) sind.

3. Verfahren nach Anspruch 2, bei dem das Siliziumoxid porös ist und der Sauerstoffanteil (x) in der Siliziumoxidschicht (12) zwischen 1,6 und 2, vorzugsweise zwischen 1,8 und 1,9 beträgt.

4. Verfahren nach einem der Ansprüche 2 oder 3, bei dem das Siliziumoxid porös ist und die Dicke ($t_{OX}$) der Siliziumoxidschicht (12) zwischen 4 nm und 7 nm beträgt.

5. Verfahren nach einem der Ansprüche 2 bis 4, bei dem das Siliziumoxid porös ist und die Dicke ($t_{TE}$) der zweiten Elektrode (13) zwischen 3 nm und 7 nm beträgt.

6. Verfahren nach Anspruch 2, bei dem das Siliziumoxid nicht-porös ist und der Sauerstoffanteil (x) in der Siliziumoxidschicht (12) zwischen 1 und 1,6, vorzugsweise zwischen 1,2 und 1,4 beträgt.

7. Verfahren nach einem der Ansprüche 2 und 6, bei dem das Siliziumoxid nicht-porös ist und die Dicke ($t_{OX}$) der Siliziumoxidschicht (12) zwischen 3 nm und 4 nm beträgt.

8. Verfahren nach einem der Ansprüche 2, 6 oder 7, bei dem das Siliziumoxid nicht-porös ist und die Dicke ($t_{TE}$) der zweiten Elektrode (13) zwischen 4 nm und 6 nm beträgt.

9. Verfahren nach einem der Ansprüche 1 bis 8, bei dem die Siliziumoxidschicht (12) durch Sputtern gebildet wird.

10. Verfahren nach einem der Ansprüche 1 bis 9, bei dem die erste und die zweite Elektrode (11, 13) durch Sputtern gebildet werden.

11. Verfahren nach einem der Ansprüche 1 bis 10, bei dem die erste Elektrode (11) aus Titannitrid und die zweite Elektrode (13) aus Titan besteht.

**Claims**

1. Method for manufacturing an OxRAM type resistive memory cell comprising a silicon oxide layer (12), said method comprising the following steps:

- determining values ($t_{TE\_opt}$, $t_{OX\_opt}$, $x_{opt}$) of manufacturing parameters ($t_{TE}$, $t_{OX}$, x) enabling the resistive memory cell to have an initial resistance ($R_i$) before a conductive filament is formed for the first time comprised between $10^7$ $\Omega$ to $3 \cdot 10^9$ $\Omega$, preferably between $3 \cdot 10^7$ $\Omega$ and $10^9$ $\Omega$;
- forming on a substrate a stack successively comprising a first electrode (11), the silicon oxide layer (12) and a second electrode (13), by applying said manufacturing parameter values.

2. Method according to claim 1, wherein the manufacturing parameters are the thickness of the second electrode ($t_{TE}$), the thickness of the oxide layer ($t_{OX}$) and the proportion of oxygen (x) in the oxide layer (12).

3. Method according to claim 2, wherein the silicon oxide is porous and wherein the proportion of oxygen (x) in the silicon oxide layer (12) is comprised between 1.6 and 2, preferably between 1.8 and 1.9.

4. Method according to one of claims 2 and 3, wherein the silicon oxide is porous and wherein the thickness ($t_{OX}$) of the silicon oxide layer (12) is comprised between 4 nm and 7 nm.

5. Method according to any of claims 2 to 4, wherein the silicon oxide is porous and wherein the thickness ($t_{TE}$) of the second electrode (13) is comprised between 3 nm and 7 nm.

6. Method according to claim 2, wherein the silicon oxide is non-porous and wherein the proportion of oxygen (x) in the silicon oxide layer (12) is comprised between 1 and 1.6, preferably between 1.2 and 1.4.

7. Method according to one of claims 2 and 6, wherein the silicon oxide is non-porous and wherein the thickness ($t_{OX}$) of the silicon oxide layer (12) is comprised between 3 nm and 4 nm.

8. Method according to any of claims 2, 6 and 7, wherein the silicon oxide is non-porous and wherein the thickness ($t_{TE}$) of the second electrode (13) is comprised between 4 nm and 6 nm.

9. Method according to any of claims 1 to 8, wherein the silicon oxide layer (12) is formed by cathodic sputtering.

10. Method according to any of claims 1 to 9, wherein the first and second electrodes (11, 13) are formed by cathodic sputtering.

11. Method according to any of claims 1 to 10, wherein the first electrode (11) is made of titanium nitride and the second electrode (13) is made of titanium.

# Fig. 1

| | |
|---|---|
| -S2- | Mesurer $R_i$ des n cellules |

| | |
|---|---|
| -S3- | Programmer le n cellules dans l'état HRS |

| | |
|---|---|
| -S4- | Mesurer $R_{HRS}$ des n cellules |

| | |
|---|---|
| -S5- | Établir la relation $R_{HRS}(R_i)$ |

| | |
|---|---|
| -S6- | $R_{HRS}(R_i)$, $R_{HRS\_tg} => R_{i\_opt}$ |

| | |
|---|---|
| -S7- | $R_{i\_opt} => \{t_{TE\_opt}, t_{OX\_opt}, X_{opt}\}$ |

# Fig. 2

# Fig. 3

# Fig. 4

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- US 2016276411 A
- JP 2016076655 A